# EUROPÄISCHE PATENTANMELDUNG

(11) **EP 2 511 986 A2**
(43) Veröffentlichungstag der Anmeldung: **17.10.2012**
(21) Anmeldenummer: 12159296.8
(22) Anmeldetag: 13.03.2012
(51) Int. Cl.: H01R 12/71, H01R 13/24

(54) **Elektrische Anordnung**

(30) Priorität: 15.04.2011 DE 102011007485
(71) Anmelder: Robert Bosch GmbH, 70442 Stuttgart (DE)
(72) Erfinder: Schoenfeld, Michael, 70771 Leinfelden-Echterdingen (DE)

(57) **Zusammenfassung**

Die Erfindung betrifft eine elektrische Anordnung, umfassend: eine Trägerplatte (2) mit einem Hauptbereich (21) und einen in einem Winkel (α) abgewinkelten Bereich (22), wobei am abgewinkelten Bereich (22) zumindest ein erster elektrischer Kontaktbereich (31) angeordnet ist, und wobei der erste elektrische Kontaktbereich (31) freiliegend ist, und ein Direktsteckelement (4) mit zumindest einem ersten Direktkontakt (41), wobei der erste Direktkontakt (41) den ersten Kontaktbereich (31), kontaktiert.

## Beschreibung

### Stand der Technik

Die vorliegende Erfindung betrifft eine verbesserte Mehrfach-Direktkontaktierung von elektronischen Bauteilen, wie z. B. Leiterplatten, sowie eine Leiterplatte mit verbesserten Direktkontaktierungsmöglichkeiten.

In jüngster Zeit werden verstärkt Direktsteckkontakte verwendet, bei denen ein Direktsteckelement unmittelbar auf eine Leiterplatte gesteckt wird. Bei einer Vielzahl von Kontaktbereichen an der Leiterplatte werden die Kontaktbereiche dabei in einer Reihe nahe einer Leiterplattenkante angeordnet. Wenn hierbei viele Kontaktbereiche notwendig sind, ergibt sich eine entsprechende Länge an der Leiterplatte sowie eine komplizierte Verdrahtung auf der Leiterplatte, da dadurch die Wege zwischen den Kontaktbereichen und Bauelementen an der Leiterplatte mit der Anzahl der Kontaktbereiche jeweils vergrößert werden müssen. Um die Anzahl der Kontakte zu erhöhen, könnte man Kontaktbereiche sowohl an einer Oberseite als auch an einer Unterseite der Leiterplatte vorsehen. Je nach Anzahl der notwendigen Kontaktbereiche an der Leiterplatte ergeben sich dabei jedoch immer noch relativ lange Kontaktreihen. Es ist jedoch wünschenswert, insbesondere bei Massenprodukten, wie beispielsweise Steuergeräten für Fahrzeuge, bei denen eine Vielzahl von gleichen Steuergeräten benötigt wird, eine möglichst wirtschaftliche Herstellung der Kontaktierung zu ermöglichen.

### Offenbarung der Erfindung

Die erfindungsgemäße elektrische Anordnung mit den Merkmalen des Anspruchs 1 umfasst eine Trägerplatte, wie beispielsweise eine Leiterplatte, und ein Direktsteckelement. Dabei weist die erfindungsgemäße Anordnung neben einem sehr einfachen und kostengünstig herzustellenden Aufbau den Vorteil einer möglichen Kontaktierung in Längsrichtung auf. Dies wird erfindungsgemäß dadurch erreicht, dass die Trägerplatte einen Hauptbereich und einen in einem Winkel zum Hauptbereich abgewinkelten Bereich aufweist, an dem ein zumindest ein freiliegender Kontaktbereich angeordnet ist, der mit zumindest einem Direktkontakt des Direktsteckelements kontaktiert werden kann.

Die Unteransprüche zeigen bevorzugte Weiterbildungen der Erfindung.

Vorzugsweise ist am abgewinkelten Bereich ein zweiter, freiliegender elektrischer Kontaktbereich angeordnet. Hierbei sind der erste elektrische Kontaktbereich in einer ersten Ebene und der zweite elektrische Kontaktbereich in einer zweiten Ebene angeordnet, wobei die erste Ebene parallel zur zweiten Ebene und parallel zum Hauptbereich der Trägerplatte ist. Hierdurch wird eine kompakte, insbesondere mehrreihige Anordnung von Kontaktbereichen erreicht, die alle in Längsrichtung kontaktierbar sind. Ferner wird dadurch eine sehr einfache und kompakte Bauform mit minimalen Bauvolumen der Anordnung realisiert.

Gemäß einer weiteren bevorzugten Ausgestaltung der vorliegenden Erfindung weist das Direktsteckelement einen zweiten Direktkontakt auf, welcher den zweiten Kontaktbereich kontaktiert, wobei der erste Direktkontakt in der ersten Ebene liegt und der zweite Direktkontakt in der zweiten Ebene liegt. Hierdurch wird eine mehrreihige Anordnung der Direktkontakte mit gleicher Kontaktrichtung zu den Kontaktbereichen der Leiterplatte erreicht, wodurch eine betriebssichere Kontaktierung begünstigt wird.

Weiterhin bevorzugt sind alle Direktkontakte baugleich. Durch die mögliche Verwendung ein und desselben Typs von Direktkontakten wird eine besonders wirtschaftliche bzw. kosteneffiziente Massenfertigung der Bauteile erreicht.

In weiterer bevorzugte Ausgestaltung sind die Direktkontakte im Direktsteckelement in einer Längsrichtung des Direktsteckelements jeweils in einem Abstand versetzt zueinander angeordnet. Hierdurch resultieren gleich lange Wege für die Kontaktierung mit den Kontaktbereichen der Leiterplatte, wodurch eine sehr kompakte Bauform mit minimaler Baulänge des Direktsteckelements erreicht wird.

Gemäß einer weiteren bevorzugten Ausgestaltung der Erfindung ist ein Moldgehäuse vorgesehen, wobei die Trägerplatte derart im Moldgehäuse angeordnet ist, dass zumindest eine Außenseite des abgewinkelten Bereichs, an welcher die Kontaktbereiche angeordnet sind, außerhalb des Moldgehäuses liegt. Neben einem zuverlässigen Schutz gegen Umwelteinflüsse kann das Moldgehäuse darüber hinaus beispielsweise als Anschlag für ein Gehäuse des Direktsteckelements dienen. Weiter bevorzugt ist eine Unterseite des abgewinkelten Bereichs ebenfalls vom Moldgehäuse überdeckt

Vorzugsweise umfasst das Direktsteckelement wenigstens ein Federelement, welches auf die Direktkontakte eine Federkraft ausübt, um die Direktkontakte gegen die Kontaktbereiche zu drücken. Hierdurch wird ein betriebssicherer Kontakt unter allen Betriebsbedingungen des jeweiligen Einsatzes gewährleistet.

Weiterhin bevorzugt ist eine Rastverbindung zwischen dem Moldgehäuse und dem Direktsteckelement gebildet. Hierdurch wird eine dauerhaft zuverlässige Fixierung des Direktsteckelements an der Trägerplatte sichergestellt.

Die Erfindung betrifft ferner eine Trägerplatte, insbesondere Leiterplatte, die einen Hauptbereich und einen in einem Winkel zum Hauptbereich abgewinkelten Bereich umfasst. Der abgewinkelte Bereich definiert somit eine Fläche, an welcher ein oder vorzugsweise eine Vielzahl von freiliegenden Kontaktbereichen mehrreihig angeordnet werden können, und die einen vorteilhaften Direktkontakt in Längsrichtung der Trägerplatte ermöglicht. Vorzugsweise ist die Trägerplatte einstückig ausgebildet. Weiter bevorzugt ist der abgewinkelte Bereich mit einem Winkel α zwischen 0° und 90°, vorzugsweise 45°, abgewinkelt ausgebildet.

Die Erfindung betrifft ferner ein Steuergerät für ein Fahrzeug welches eine erfindungsgemäße elektrische Anordnung oder eine erfindungsgemäße Trägerplatte umfasst.

### Zeichnung

Nachfolgend wird ein bevorzugtes Ausführungsbeispiel der Erfindung unter Bezugnahme auf die begleitende Zeichnung im Detail beschrieben. In der Zeichnung ist:
- Figur 1: eine schematische Schnittansicht einer elektrischen Anordnung gemäß einem Ausführungsbeispiel der Erfindung, und
- Figur 2: eine schematische Draufsicht auf einen abgewinkelten Bereich einer Trägerplatte der Anordnung von Figur 1.

Bevorzugte Ausführungsform der Erfindung

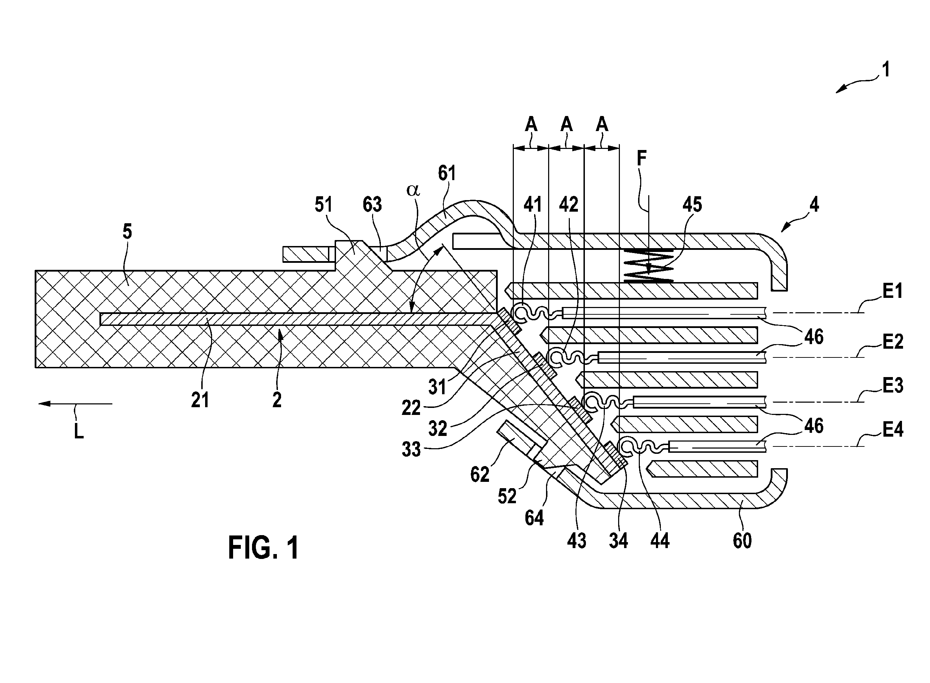

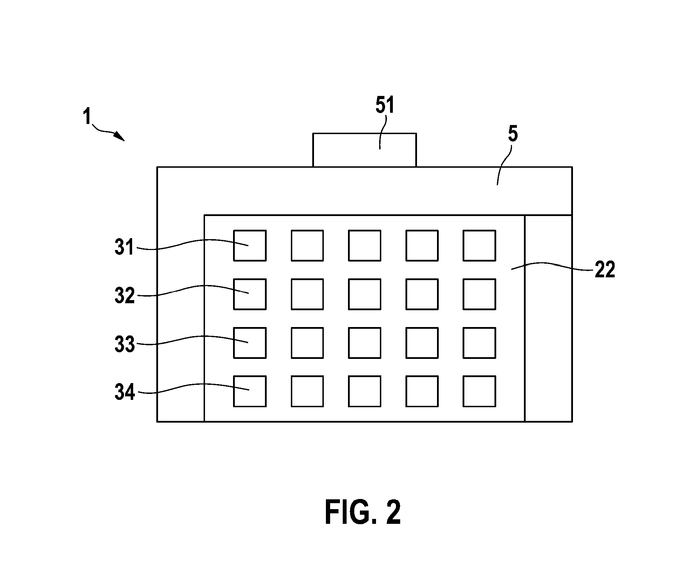

Nachfolgend wird unter Bezugnahme auf die Figuren 1 und 2 eine elektrische Anordnung gemäß einem bevorzugten Ausführungsbeispiel der Erfindung im Detail beschrieben.

Wie aus Figur 1 ersichtlich ist, umfasst die elektrische Anordnung eine Trägerplatte 2, welche in diesem Ausführungsbeispiel eine einstückig ausgebildete Leiterplatte ist, und ein Direktsteckelement 4. Die Trägerplatte 2 ist teilweise von einem Moldgehäuse 5 umgeben und weist einen Hauptbereich 21 und einen zum Hauptbereich 21 abgewinkelten Bereich 22 auf. Ein Winkel α zwischen dem Hauptbereich 21 und dem abgewinkelten Bereich 22 beträgt hierbei vorzugsweise 45°, kann alternativ aber auch einen anderen Wert zwischen 0° und 90° aufweisen. Eine dem Direktsteckelement 4 zugewandte Außenseite des abgewinkelten Bereichs 22 ist hierbei freiliegend, d. h. nicht vom Moldgehäuse 5 umgeben. Am freiliegenden abgewinkelten Bereich 22 sind ferner ein erster elektrischer Kontaktbereich 31, ein zweiter elektrischer Kontaktbereich 32, ein dritter elektrischer Kontaktbereich 33 und ein vierter elektrischer Kontaktbereich 34 in gleichem Abstand zueinander angeordnet. Wie aus Figur 2 ersichtlich, sind die elektrischen Kontaktbereiche 31, 32, 33, 34 hierbei vorzugsweise in vier parallelen Reihen mit jeweils fünf nebeneinander bzw. auf einer Linie angeordneten Kontaktflächen (Lands) angeordnet. Alternativ ist auch eine Anordnung mit einer beliebigen Anzahl von Kontaktbereichen sowie Kontaktflächen auf dem abgewinkelten Bereich 21 möglich.

Das Direktsteckelement 4 umfasst, wie weiter aus Figur 1 ersichtlich ist, ein Gehäuse 60 sowie einen ersten Direktkontakt 41, einen zweiten Direktkontakt 42, einen dritten Direktkontakt 43 und einen vierten Direktkontakt 44. Die Direktkontakte 41, 42, 43, 44 sind jeweils in zum Hauptbereich 21 der Trägerplatte 2 parallelen Ebenen E1, E2, E3, E4 angeordnet und jeweils über ein Kabel 46 elektrisch angeschlossen. Wie in Figur 1 gezeigt, verlaufen die Kabel 46 hierbei jeweils in separaten, durch Gehäusewände unterteilten Bereichen. Die Direktkontakte 41, 42, 43, 44 sind jeweils baugleich. Hierdurch ergeben sich große herstellungsbedingte wirtschaftliche Vorteile. Die Direktkontakte 41, 42, 43, 44 sind dabei als Federzungen ausgebildet und können mittels bekannter Verfahren an den Kabeln 46 befestigt werden.

Wie in Figur 1 gezeigt, sind die Direktkontakte 41, 42, 43, 44 dabei in einer Längsrichtung L jeweils in einem Abstand A derart zueinander angeordnet, dass sie die jeweils entsprechenden Kontaktbereiche 31, 32, 33, 34 kontaktieren. Im Gehäuse 60 sind ferner Federelemente 45 angeordnet, welche auf die Direktkontakte 41, 42, 43, 44 eine Federkraft F senkrecht zur Längsrichtung L ausüben, um die Direktkontakte 41, 42, 43, 44 gegen die Kontaktbereiche 31, 32, 33, 34 zu drücken und eine betriebssichere Direktkontaktierung sicherzustellen. Am Moldgehäuse 5 sind ferner ein erstes Rastelement 51 sowie ein zweites Rastelement 52 ausgebildet. Am Direktsteckelement 4 ist eine erste Lasche 61 mit einer Öffnung 63 sowie eine zweite Lasche 62 mit einer Öffnung 64 ausgebildet. Wie aus Figur 1 ersichtlich ist, wird eine Rastverbindung zwischen dem Moldgehäuse 5 und dem Direktsteckelement 4 dadurch gebildet, dass das erste Rastelement 51 in die Öffnung 63 der ersten Lasche 61 eingreift und das zweite Rastelement 52 in die Öffnung 64 der zweiten Lasche 62 eingreift.

Somit ist es erfindungsgemäß möglich, dass baugleiche Direktkontakte 41, 42, 43, 44 verwendet werden, welche in verschiedenen Ebenen E1, E2, E3, E4 am Direktsteckelement 4 angeordnet sind und mehrreihige Kontaktbereiche 31, 32, 33, 34 am abgewinkelten Bereich 22 einer Leiterplatte kontaktieren. Dadurch kann eine auf verschiedenen Ebenen vorgesehene, mehrreihige Direktkontaktierung mit in Längsrichtung minimierter Baulänge realisiert werden. Ferner kann insbesondere eine sehr kostengünstige Herstellung der Direktkontakte realisiert werden. Die Erfindung kann vorzugsweise in Steuergeräten von Fahrzeugen, beispielsweise Einspritzsteuergeräten oder Getriebesteuergeräten oder Motorsteuergeräten, verwendet werden.

## Patentansprüche

1. Elektrische Anordnung, umfassend:
- eine Trägerplatte (2) mit einem Hauptbereich (21) und einem in einem Winkel (α) zum Hauptbereich (21) abgewinkelten Bereich (22), und
- ein Direktsteckelement (4) mit zumindest einem ersten Direktkontakt (41),
- wobei am abgewinkelten Bereich (22) zumindest ein erster elektrischer Kontaktbereich (31) angeordnet ist,
- wobei der erste elektrische Kontaktbereich (31) freiliegend ist, und
- wobei der erste Direktkontakt (41) mit dem ersten Kontaktbereich (31) in Kontakt bringbar ist.

2. Anordnung nach Anspruch 1, **dadurch gekennzeichnet, dass** am abgewinkelten Bereich (22) ein zweiter freiliegender elektrischer Kontaktbereich (32) angeordnet ist, wobei der erste elektrische Kontaktbereich (31) in einer ersten Ebene (E1) und der zweite elektrische Kontaktbereich (32) in einer zweiten Ebene (E2) angeordnet ist, wobei die erste Ebene (E1) parallel zur zweiten Ebene (E2) und parallel zum Hauptbereich (21) der Trägerplatte (2) ist.

3. Anordnung nach Anspruch 2, **dadurch gekennzeichnet, dass** das Direktsteckelement (4) einen zweiten Direktkontakt (42) aufweist, welcher den zweiten Kontaktbereich (32) kontaktiert, wobei die erste Direktkontakt (41) in der ersten Ebene (E1) liegt und der zweite Direktkontakt (42) in der zweiten Ebene (E2) liegt.

4. Anordnung nach einem der vorhergehenden Ansprüche, **dadurch gekennzeichnet, dass** alle Direktkontakte (41, 42, 43, 44) baugleich sind.

5. Anordnung nach einem der vorhergehenden Ansprüche, **dadurch gekennzeichnet, dass** die Direktkontakte (41, 42, 43, 44) im Direktsteckelement (4) in einer Längsrichtung (L) des Direktsteckelements (4) jeweils in einem Abstand (A) versetzt zueinander angeordnet sind.

6. Anordnung nach einem der vorhergehenden Ansprüche, ferner umfassend ein Moldgehäuse (5), wobei die Trägerplatte (2) derart im Moldgehäuse (5) angeordnet ist, dass zumindest eine Außenseite des abgewinkelten Bereichs (22) außerhalb des Moldgehäuses (5) liegt.

7. Anordnung nach einem der vorhergehenden Ansprüche, **dadurch gekennzeichnet, dass** das Direktsteckelement (4) wenigstens ein Federelement (45) umfasst, welches auf die Direktkontakte (41, 42, 43, 44) eine Federkraft (F) ausübt, um die Direktkontakte (41, 42, 43, 44) gegen die Kontaktbereiche (31, 32, 33, 34) zu drücken.

8. Anordnung nach einem der Ansprüche 6 oder 7, **dadurch gekennzeichnet, dass** eine Rastverbindung zwischen dem Moldgehäuse (5) und dem Direktsteckelement (4) gebildet ist.

9. Trägerplatte, insbesondere Leiterplatte, umfassend einen Hauptbereich (21) und einen in einem Winkel (α) zum Hauptbereich (21) abgewinkelten Bereich (22), wobei am abgewinkelten Bereich (22) zumindest ein erster elektrischer Kontaktbereich (31) angeordnet ist, und wobei der erste elektrische Kontaktbereich (31) freiliegend ist.

10. Steuergerät für ein Fahrzeug, umfassend eine elektrische Anordnung nach einem der Ansprüche 1 bis 8 oder eine Trägerplatte nach Anspruch 9.
